# EUROPEAN PATENT APPLICATION

(11) **EP 4 766 072 A1**
(43) Date of publication of application: **24.06.2026**
(21) Application number: 24307229.5
(22) Date of filing: 20.12.2024
(51) Int. Cl.: H10D 1/00, H10D 1/66, H10D 84/00

(54) **ELECTRICAL DEVICE INCLUDING A CAPACITOR FOR HIGH-VOLTAGE APPLICATIONS AND METHOD FOR MANUFACTURING THEREOF**

(71) Applicant: Murata Manufacturing Co., Ltd., Nagaokakyo-shi, Kyoto 617-8555 (JP)
(72) Inventor: VOIRON, Frédéric, 14000 CAEN (FR); BUFFLE, Larry, 14000 CAEN (FR)
(74) Representative: Cabinet Beau de Loménie

(57) **Abstract**

The present invention relates to an electrical device (100) comprising a capacitor for high-voltage applications and method for manufacturing thereof. In particular, the proposed electrical device (100) includes a capacitor comprising:
- a bottom electrode (110) comprising a semiconductor substrate (111),
- a dielectric (120) extending conformally on the bottom electrode (110),
- a top electrode (130) on the dielectric (120),
wherein the substrate (111) comprises:
- a first region of a first doping type (113) extending from a bottom surface of the substrate (111-BS) up to a top surface of the substrate (111-TS),
- second regions of a second doping type (114) having opposite charge carriers in comparison with the first doping type and extending from the top surface of the substrate (111-TS) down to a given depth (111-D).

## Description

### Field of the Invention

The present invention relates to the field of electrical devices and particularly to the field of power electronics. More precisely, the present invention concerns an electrical device comprising a capacitor for high-voltage applications and the method for manufacturing thereof.

The present invention is particularly advantageous for implementing a decoupling or snubber capacitive element for high-voltage applications (e.g., exceeding 900V, and preferably in the range from 1200V to 2000V), but such an application is only given as an illustrative example and should not limit the invention.

### Background of the Invention

The present invention lies in particular within the context of electrical devices comprising capacitors with high capacitance density and intended for high-voltage applications.

In this context, it is known to use three-dimensional capacitors formed using a semiconductor substrate with reliefs on which a thick dielectric structure extends. On the one hand, the use of a capacitor formed on a semiconductor substrate with reliefs allows increasing the specific surface area of the capacitor and achieving a high capacitance density. On the other hand, the use of a thick dielectric in the capacitive structure allows withstanding reliably high voltages.

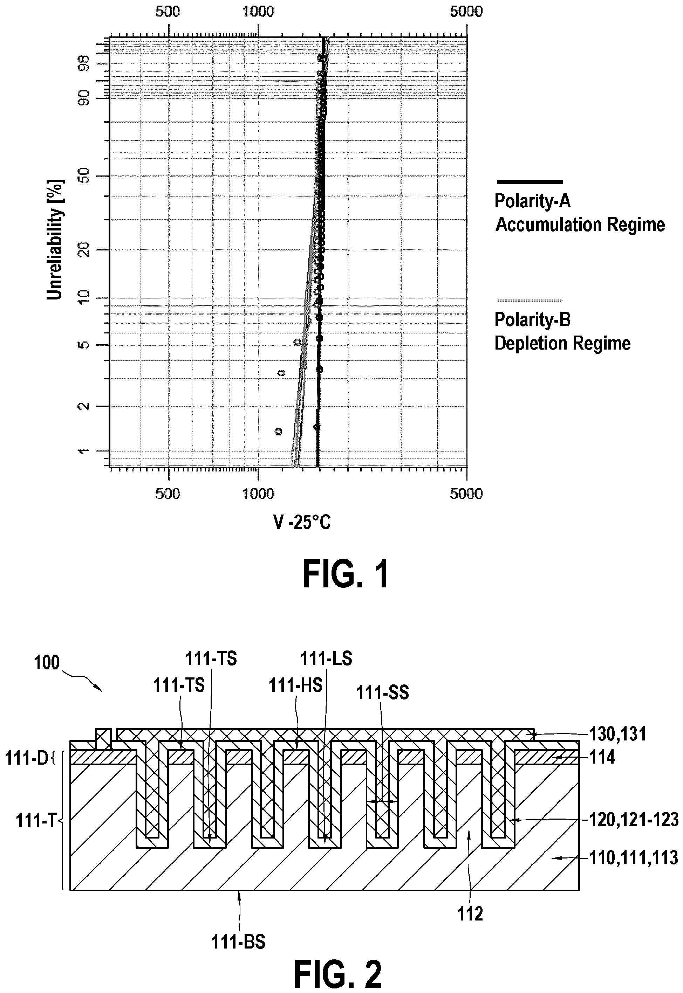

However, the existing capacitors described above exhibit certain limitations. The electrical tests conducted by the inventors on these capacitors have identified reliability concerns. More specifically, as illustrated in FIG. 1, these electrical tests have shown that these capacitors may experience breakdown at lower voltages when operated under one polarity, as compared to the opposite polarity. This may compromise the reliability of the capacitor and may require limiting the maximum voltage to ensure reliable operation.

Therefore, there exists a need for a capacitor with a high capacitance density and capable of reliably withstanding high voltages under both polarities.

### Summary of the Invention

The present invention has been made in the light of the above problems.

According to an aspect, the present invention provides an electrical device including a capacitor comprising:
- a bottom electrode structure comprising a semiconductor substrate, the substrate having facing protruding walls extending upwards,
- a dielectric structure comprising one or more dielectric layers and extending conformally on the protruding walls of the substrate, and
- a top electrode structure comprising at least one conductive layer and extending conformally on the dielectric structure, the capacitor being formed by the bottom electrode structure and the top electrode structure facing each other and separated by the dielectric structure,
   wherein:
- the substrate comprises a first region of a first doping type extending from a bottom surface of the substrate up to a top surface of the substrate (opposite to the bottom surface),
- the substrate comprises one or more second regions of a second doping type, the first doping type and the second doping type having opposite charge carriers,
- said one or more second regions of the second doping type extend from the top surface of the substrate down to a given depth of the substrate and extend only partially over the top surface of the substrate, and
- the dielectric structure extends on the first region of the first doping type and on said one or more second regions of the second doping type.

The present invention proposes forming a three-dimensional capacitor using a particular semiconductor substrate which allows reliably withstanding high voltages under both polarities.

In the proposed solution, the substrate has its main portion of a first doping type (said first region) and secondary portions of a second doping type (said second regions). The first and second doping types have opposite charge carriers (e.g., p-doping and n-doping, or vice versa).

More specifically, the second regions (also referred to hereinafter as *"reverse-doped pockets"*) are arranged at the top surface of the substrate and extend downwards to a certain depth. They only partially cover the top surface of the substrate, so that the dielectric structure extends over both the first region of the first doping type and the second regions of the second doping type. These reverse-doped pockets allow the capacitor to reliably withstand high voltages in both polarities (This is further detailed hereinafter).

As previously mentioned, electrical tests have shown that existing capacitors using a semiconductor substrate may experience breakdown at lower voltages when operated under one polarity, as compared to the opposite polarity. The inventors have observed that these capacitors experience breakdown at lower voltages when the polarity is such that the semiconductor substrate is in depletion regime. When the capacitor is operated in this regime with high frequency alternating signal (e.g., AC voltage or current with a frequency above 1 kHz, or even above 1Hz), the generation of minority carriers in the substrate and the drift of those carriers to the interface with the dielectric (i.e., near the top surface of the substrate) is not sufficiently rapid to compensate for the charges on the other electrode. In other words, the buildup of an inversion layer supplied by minority carriers generated in the substrate is not sufficiently rapid to achieve opposite electrode charge compensation. This means that a residual electrical field remains in the substrate, induced by the potential applied on the opposite electrode. The magnitude of the electrical field depends upon the opposite electrode potential, and contributes to accelerating the minority carriers towards the dielectric. These minority carriers eventually impact the interface with the dielectric (these carriers are also referred to as *"hot carriers"*). This can lead to accelerated wear-out of the dielectric and, more critically, can trigger a breakdown of the capacitor. If the potential set to the opposite electrode is high enough, the electrical field can reach magnitude exceeding 70kV/cm and lead to the substrate breakdown by ionization.

In contrast, in the proposed electrical device, the second regions of the second doping type (i.e., the reverse-doped pockets) in the substrate act as injection sources of minority carriers at the interface with the dielectric. This accelerates the generation of minority carriers and provides a more rapid charge compensation (i.e., improves the kinetic for substrate inversion). This contributes to limiting the magnitude of the electrical field in the substrate during transient and reduces the occurrences of hot carriers within the substrate. It therefore reduces early dielectric wear-out and eventually prevents early breakdown of the capacitor. The proposed solution provides an improved reliability of the capacitor under both polarities. An improved linearity of the capacitor (with respect to capacitance as a function of the voltage) also follows as a result.

Furthermore, the use of a substrate with reliefs (The protruding walls facing each other) allows increasing the specific surface area of the capacitor. This results in a high capacitance density.

For these reasons, the proposed solution provides a capacitor with a high capacitance density that can reliably withstand high voltages under both polarities.

In a particular embodiment, said second regions of the second doping type extend only in a peripheral region of the substrate.

It should be noted that the central region of the substrate comprises the reliefs formed by the protruding walls, whereas the peripheral region of the substrate does not comprise the reliefs formed by the protruding walls but comprises the reverse-doped pockets (said second regions). The peripheral region extends up to the edges of the electrical device and surrounds the central region comprising the reliefs.

In this configuration, it is preferred that the top electrode structure extends over the peripheral region. Indeed, it is preferred that the edge of the top electrode overlaps at least the diffusion region into the substrate. It is recalled that, when a PN junction is formed, a diffusion region forms on both sides of the geometrical junction, this diffuse region being rich in minority carriers. Therefore, it is preferred that this diffusion region is in the electrical field formed by the capacitor electrodes or at least in the fringing field at the edge of the capacitor electrodes.

As previously mentioned, the proposed reverse-doped pockets act as injection sources of minority carriers in the substrate at the interface with the dielectric and thereby is favorable to the buildup of an inversion layer limiting the magnitude of the electrical field in the substrate, reducing the occurrences of hot carriers and as a consequence limiting the wear-out kinetic and early breakdown of the capacitor. In this embodiment, the reverse-doped pockets are arranged only in the peripheral region of the substrate. This arrangement is advantageous in that it sufficiently increases the injection of minority carriers)

In a particular embodiment, said second regions of the second doping type extend over substantially the entire of a highest surface of the substrate.

We distinguish here: i) the top surface of the substrate which includes the reliefs formed by the protruding walls, and ii) the highest surface of the substrate which is substantially planar and does not include the reliefs formed by the protruding walls. The top surface of the substrate includes the highest surface of the substrate, the side surfaces of the protruding walls, and the lower surface in between the protruding walls.

In this embodiment, the reverse-doped pockets (said second regions) extend over substantially the entire highest surface of the substrate. In other words, the reverse-doped pockets extend over the summits of the protruding walls. The reverse-doped pockets can thus be formed by performing a full-sheet doping of the wafer (without any patterning mask). This is advantageous in that the reverse-doped pockets can be formed without the need for an additional photolithography step and have a minor impact on the capacitance density of the capacitor. Also, the quantity of available minority carriers is larger (i.e., correlated to the surface of the reverse-doped pockets) and distributed all over the area of the capacitive structure. In that respect, the distance to be drifted by the minority carriers along the interface is reduced which reduces the risk of recombination.

It is important to note here that the reverse-doped pockets do not extend over the entire top surface of the substrate. The reverse-doped pockets do not extend over the side surfaces of the protruding walls and do not extend over the lower surface in between the protruding walls. Assuming that the protruding walls form trenches, then the reverse-doped pockets extend over the summits of the protruding walls, but do not extend into the bottom of the trenches. It follows that the dielectric structure extends on both the first region of the first doping type and on the reverse-doped pockets.

In a particular embodiment, the given depth of the substrate, to which said second regions of the second doping type extend, is equal to or less than 30% of a thickness of the substrate.

For instance, the given depth of the substrate, to which the second regions of the second doping type extend, is comprised between 5% and 20% of the total thickness of the substrate.

This arrangement specifies a particular depth of the substrate to which the reverse-doped pockets extend. The particular depth specified in this arrangement can be obtained by using a tilted implant for doping the substrate with a dopant of the second type to form the reverse-doped pockets. This arrangement is particularly advantageous in that it sufficiently increases the injection of minority carriers at the interface with the dielectric (to prevent the early/random breakdown of the capacitor as a result of faster wear-out) and further reduces the distance to be drifted along the interface by the minority carriers.

In a particular embodiment, at least one of said second regions of the second doping type is electrically connected only to the bottom electrode structure and is electrically insulated from the top electrode structure.

In this embodiment, all or part of the reverse-doped pockets are electrically insulated from other electrical components or structures. In particular, they are insulated from the top electrode.

This embodiment proposes using the thermionic diffusion of the reverse-doped pockets (said second regions) to improve minority carrier generation (i.e., no reverse bias source is used). This is advantageous in that it provides a particularly low implementation complexity. This contributes to providing a capacitor capable of withstanding high voltages in both polarities and with a low implementation complexity.

In a particular embodiment, the electrical device further comprises:
- a first external terminal electrically connected to the top electrode structure,
- a second external terminal electrically connected to the bottom electrode structure,
- a third external terminal electrically connected to at least one of said second regions of the second doping type.

This embodiment provides an external terminal connected to the reverse-doped pockets (said second regions) - in addition to the external terminals connected to the capacitor electrodes. This allows connecting an external voltage supply to the reverse-doped pockets, acting as a reverse bias source. This allows increasing the minority carrier injection through the reverse-doped pockets. The external voltage supply can also be used to dynamically control the source of the reversed bias.

Correlatively, the present invention provides a system comprising the proposed electrical device, a voltage supply source connected to the first and second external terminals of the electrical device (i.e., connected to the capacitor electrodes), and another voltage supply source connected to the third external terminals of the electrical device (i.e., connected to the reverse-doped pockets).

In a particular embodiment, the electrical device comprises only two external terminals respectively connected to the top and bottom electrode structures, and at least one of said second regions of the second doping type is internally connected with the top electrode structure and/or the bottom electrode structure.

This embodiment proposes using the voltage supply connected to the capacitor electrodes as a reverse bias source. The latter is used to increase the minority carrier injection through the reverse-doped pockets and prevent the breakdown of the capacitor. This embodiment provides a capacitor capable of withstanding reliably high voltages under both polarities and that is particularly easy to use.

Correlatively, the present invention provides a system comprising the proposed electrical device and a voltage supply connected to the two external terminals of the electrical device.

In a particular embodiment, at least one of said second regions of the second doping type is electrically connected to the top electrode structure through a capacitive structure and is also electrically connected to the bottom electrode structure through another capacitive structure.

As mentioned above, the use of existing capacitors based on a semiconductor substrate with high frequency alternating current (e.g., a frequency above 1kHz, or even above 1Hz) may result in reliability issues. The generation of minority carriers in the substrate (i.e., the inversion of the substrate) is not sufficiently rapid to achieve charge compensation.

In this embodiment, the voltage supply connected to the capacitor electrodes is used as a reverse bias source to increase the minority carrier injection in the substrate through the reverse-doped pockets. This embodiment further proposes connecting these second regions to the capacitor electrodes through capacitive structures. This allows filtering low-frequency signals (without using external capacitors), so that minority carrier injection is increased for high-frequency signals (i.e., only when necessary).

Thereby, this embodiment contributes to providing a capacitor capable of withstanding high voltages in both polarities and with a low implementation complexity.

In a particular embodiment:
- the capacitive structure connecting said second regions of the second doping type to the top electrode structure comprises:
   ∘ i) a conductive layer of the top electrode structure and ii) a conductive layer electrically connected to said second regions of the second doping type, facing each other and separated by an insulating layer,
- the other capacitive structure connecting said second regions of the second doping type to the bottom electrode structure comprises:
   ∘ i) the first region of the first doping type of the substrate and ii) a conductive layer electrically connected to said second regions of the second doping type, facing each other and separated by the dielectric structure.

This particular arrangement has the advantages of the above-described embodiments and further offers a particularly low implementation complexity.

In a particular embodiment, the protruding walls of the substrate form one or more trenches.

This embodiment proposes forming the three-dimensional capacitor using a semiconductor substrate with trenches (e.g., a meander-shaped trench, or several linear trenches). The use of a semiconductor substrate with trenches allows using thick dielectric layers (e.g., by using wide trenches). This provides a capacitor with a high capacitance density and high breakdown voltage.

In a particular embodiment, the electrical device (100) is configured to be used with an operating voltage measured between the bottom electrode structure (110) and the top electrode structure (130) exceeding 900V, or 1200V.

For instance, the proposed electrical device may be used as a decoupling or snubber capacitive element for power electronics.

Correlatively, the present invention provides a system comprising the proposed electrical device including a capacitor and a voltage supply connected to the capacitor electrodes, wherein the operating voltage of the voltage supply exceeds 900V or 1200V.

According to an aspect, the present invention provides a method for manufacturing an electrical device (100) including a capacitor, said method comprising:
- forming a bottom electrode structure comprising a semiconductor substrate, the substrate comprising:
   ∘ facing protruding walls extending upwards,
   ∘ a first region of a first doping type extending from a bottom surface of the substrate up to a top surface of the substrate,
   ∘ one or more second regions of a second doping type, the first doping type and the second doping type having opposite charge carriers, said one or more second regions of a second doping type extending from the top surface of the substrate down to a given depth of the substrate and extending only partially over the top surface of the substrate,
   wherein forming the bottom electrode structure comprises:
      ∘ doping the substrate with a dopant of the second doping type to form said one or more second regions of a second doping type,
- forming a dielectric structure comprising one or more dielectric layers extending conformally on the protruding walls of the substrate, the dielectric structure extending on the first region of the first doping type and on said one or more second regions of the second doping type,
- forming a top electrode structure comprising one or more conductive layers and extending conformally on the dielectric structure.

The proposed manufacturing method can be adapted to obtain any one of the electrical devices defined in the present disclosure.

The embodiments of the proposed manufacturing method present the advantages described above in relation to the embodiments of the proposed electrical device.

In a particular embodiment, forming the bottom electrode structure comprises:
- forming a mask on the substrate comprising at least one opening in a peripheral region of the substrate, this mask covering a central portion of the substrate,
- doping the substrate through said at least one opening of the mask with a dopant of the second doping type to form said second regions of the second doping type, and
- etching the substrate in its central region to form the protruding walls.

In this embodiment, the reverse-doped pockets are arranged only in the peripheral region of the substrate (i.e., the region that does not comprise the reliefs formed by the protruding walls).

In a particular embodiment, forming the bottom electrode structure comprises:
- etching the substrate to form the protruding walls, and then
- full sheet doping the substrate with a dopant of the second doping type using ion implementation to form said second regions of the second doping type,

It is important to note here that the reverse-doped pockets do not extend over the entire top surface of the substrate. They do not extend over the side surfaces of the protruding walls and do not extend over the lower surface in between the protruding walls. This results from the fact that they are formed using ion implantation after the protruding walls have been formed.

In a particular embodiment, forming the bottom electrode structure comprises:
- forming a layer of the second doping type on the substrate by using full-sheet epitaxy, and then
- etching the substrate to form the protruding walls and said second regions of the second doping type.

In this embodiment also, the reverse-doped pockets do not extend over the entire top surface of the substrate. They do not extend over the side surfaces of the protruding walls and do not extend over the lower surface in between the protruding walls. This results from the fact that these reverse-doped pockets are formed by full-sheet epitaxy (without any pattering mask) and then etching the substrate to form the protruding walls.

### Brief Description of the Drawings

Further features and advantages of the present invention will become apparent from the following description of certain embodiments thereof, given by way of illustration only, not limitation, with reference to the accompanying drawings in which:
FIG. 1 illustrates experimental results related to standard capacitors (outside the scope of the present invention),
FIG. 2 illustrates a cross-section view of an electrical device according to an embodiment of the present invention,
FIGS. 3A-3C illustrate steps of a method for manufacturing an electrical device according to embodiment of the invention,
FIGS. 4A-4E illustrate electrical circuits related to different electrical devices according to embodiments of the present invention, and
FIG. 5 illustrates a cross-section view of an electrical device according to an embodiment of the present invention.

### Detailed Description of Example Embodiments

The present invention provides an electrical device comprising a capacitor with a high capacitance density that can reliably withstand high voltages under both polarities.

The present invention applies in particular to an electrical device including a 3D capacitor formed using a silicon substrate with trenches. The following description of the invention will refer to this particular application, which is only given as an illustrative example. The present invention also applies to 3D capacitive structures based on other semiconductor substrates and/or other reliefs (e.g., holes, or pillars).

**FIG. 1** illustrates experimental results related to standard capacitors.

This figure is described below to present the inventors' experiments and observations on which the present invention relies. It illustrates electrical tests performed on existing capacitors formed using a semiconductor substrate with reliefs on which a dielectric structure extends (outside the scope of the present invention).

As illustrated here, these electrical tests show that these capacitors may experience breakdown at lower voltages when operated under one polarity (polarity B - depletion regime), as compared to the opposite polarity (polarity A - accumulation regime). The inventors have observed that the capacitor experiences breakdown at lower voltages when the polarity is such that the semiconductor substrate is in depletion regime.

When the capacitor is operated in this regime with high frequency alternating signal (e.g., AC voltage or current with a frequency above 1 kHz, or even above 1Hz), the generation of minority carriers in the substrate and the drift of those carriers to the interface with the dielectric (i.e., the depletion region) is not sufficiently rapid to compensate for the charges on the other electrode. In other words, the buildup of an inversion layer supplied by minority carriers generated in the substrate is not sufficiently rapid to achieve opposite electrode charge compensation.

This means that a residual electrical field remains in the substrate, induced by the potential applied on the opposite electrode. The magnitude of the electrical field depends upon the opposite electrode potential, and contributes to accelerating the minority carriers towards the dielectric (ionization of the silicon substrate). These minority carriers eventually impact the interface with the dielectric (these carriers are also referred to as *"hot carriers"*)*.* This can lead to accelerated wear-out of the dielectric. More critically, this can lead to a catastrophic avalanche (i.e., breakdown of the silicon substrate). Leakage in the dielectric layer contributes to the charge compensation. If the potential set to the opposite electrode is high enough, the electrical field can reach magnitude exceeding 70kV/cm and lead to the silicon breakdown by ionization.

Moreover, this also implies that existing capacitors are intrinsically nonlinear (with respect to capacitance as a function of the voltage).

We describe below how the present invention allows preventing the capacitor breakdown by accelerating the generation of minority carriers in the substrate at the interface with the dielectric.

**FIG. 2** illustrates a cross-section view of an electrical device according to an embodiment of the present invention.

In the embodiment of FIG. 2, the electrical device 100 comprises a capacitor formed by: a bottom electrode structure 110, a top electrode structure 130, and a dielectric structure 120 interposed between the bottom electrode structure 110 and the top electrode structure 130.

The bottom electrode structure 110 comprises here a silicon substrate 111.

The substrate 111 comprises facing protruding walls 112 extending upwards (forming reliefs). For instance, the protruding walls 112 can form one or more trenches (e.g., a meander-shape trench, or linear trenches). The capacitor of the electrical device 100 is therefore a 3D capacitor. This allows increasing the specific area of the capacitor for a given component size and achieving a high capacitance density.

The structure of the proposed substrate 111 represents an important aspect of the present invention and will be further detailed below.

The dielectric structure 120 extends conformally over the bottom electrode structure 110 and comprises a stack of multiple dielectric layers 121-123 (stacked on each other in the bottom electrode 110 to top electrode 130 direction). It extends conformally over the protruding walls 112 of the substrate 111.

For instance, the dielectric structure 120 comprises a dielectric layer 121 comprising thermal silicon dioxide extending on (i.e., in contact with) the silicon substrate 111. The dielectric structure 120 can further comprise one or more additional dielectric layers 122-123 (e.g., silicon nitride layer(s), silicon oxide layer(s)).

The top electrode structure 130 comprises a conductive layer 131 (e.g., a layer of polysilicon) extending conformally over the dielectric structure 120.

As illustrated on FIG. 2, the top electrode structure 130 fills the above-mentioned reliefs (e.g., trenches) formed by the bottom electrode structure 110 and the dielectric structure 120. That is, the top surface of the top electrode structure 130 lies above the top surface of the dielectric structure 120.

The bottom electrode structure 110 and the top electrode structure 130 facing each other and separated by the dielectric structure 120 form the capacitor of the proposed electrical device 100.

In contrast to standard capacitors, the proposed solution uses a particular substrate 111 to form the capacitor which allows reliably withstanding high voltages under both polarities. We now detail the structure of this particular substrate 111.

The silicon substrate 111 comprises a first region of a first doping type 113 and one or more second regions of a second doping type 114.

In other words, the substrate 111 has its main portion of a first doping type (said first region) and secondary portions of a second doping type (said second regions). The first and second doping types have opposite charge carriers. For instance, the first region 113 of substrate 111 may be p-doped (e.g., doped with boron) and the second regions 114 may be n-doped (e.g., doped with phosphorus).

The first region of a first doping type 113 extends from the bottom surface 111-BS of the substrate 111-BS up to the top surface 111-TS of the substrate 111.

The second regions 114 are also referred to as *"reverse-doped pockets".* They are arranged at the top surface 111-TS of the substrate 111 and extend downwards to a given depth 111-D of the substrate 111. This depth 111-D may be equal to or less than 30% of the total thickness of the substrate 111-T. For instance, the depth 111-D may be comprised between 5% and 20% of the total thickness 111-T.

The reverse-doped pockets 114 only partially cover the top surface 111-TS of the substrate 111. Accordingly, and as illustrated in FIG. 2, the dielectric structure 120 extends over both the first region of the first doping type 113 and the reverse-doped pockets 114.

These reverse-doped pockets 114 allow the capacitor to reliably withstand high voltages in both polarities. They act as injection sources of minority carriers at the interface with the dielectric (i.e., in the depletion region) to speed up the inversion of the silicon substrate 111. This accelerates charge compensation. This contributes to limiting the magnitude of the electrical field in the substrate during transient and reduce the occurrences of hot carriers within the substrate. It therefore reduces early dielectric wear-out and eventually prevents early breakdown of the capacitor. The proposed solution therefore provides a capacitor with an improved reliability under both polarities. An improved linearity of the capacitor also follows as a result.

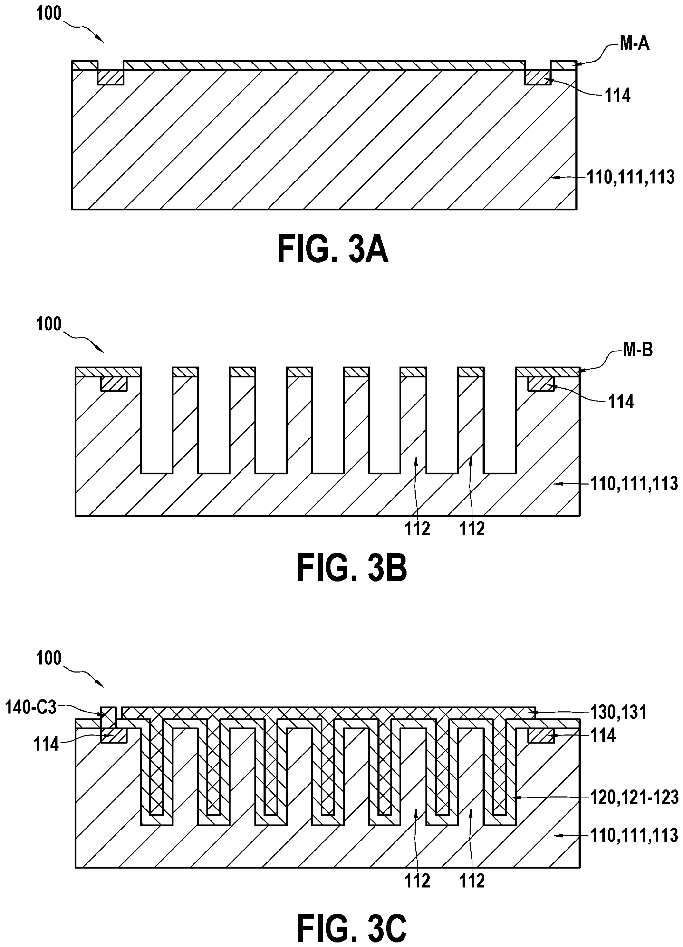

The reverse-doped pockets 114 can be implemented according to various arrangements. We describe one possible arrangement in reference to FIG. 2 and another in reference to FIG. 3A-3C.

It should first be noted that the silicon substrate 111 may comprise one or more second regions of a second type of doping 114. On the one hand, it may comprise a single continuous region of the second doping type. On the other hand, it may comprise several regions of the second doping type that are disjoint from one another.

In the embodiment of FIG. 2, the reverse-doped pockets 114 extend from a highest surface 111-HS of the substrate 111 down to the given depth 111-D.

It is important to distinguish here the top surface 111-TS of the substrate 111 from the highest surface 111-HS of the substrate. The top surface 111-TS includes the reliefs formed by the protruding walls 112. In other words, the top surface 111-TS includes the highest surface 111-HS, the side surfaces 111-SS of the protruding walls 112, and the lower surface 111-LS in between the protruding walls 112. In contrast, the highest surface 111-HS is substantially planar and does not include the reliefs formed by the protruding walls 112.

In this embodiment, the reverse-doped pockets 114 extend over substantially the entire highest surface 111-HS of the substrate 111 (but not the entire top surface 111-TS). The reverse-doped pockets 114 can thus be formed by performing a full-sheet doping of the wafer (without any patterning mask). This is advantageous in that the reverse-doped pockets 114 can be formed without the need for an additional photolithography step and have a minor impact on the high capacitance density of the capacitor.

For instance, the reversed-doped pockets 114 can be formed by: i) etching the substrate 111 to form the protruding walls 112, and then ii) full-sheet doping the substrate 111 with a dopant of the second doping type using ion implementation. Alternatively, they can also be formed by: i) forming a layer of the second doping type on the substrate 111 by using full-sheet epitaxy, and then ii) etching the substrate 111 to form the protruding walls 112.

It should also be noted that control of the interface between the substrate 111 and the dielectric structure 120 is to be considered in order to speed-up the drift of minority carriers and maximize the carrier lifetime on the interface. To this end, it is preferable to have a substrate 110 with a smooth surface and a minimum of crystalline defects (this is ensured by annealing under hydrogen H₂ at high temperature > 1100°C after etching the trenches). To further reduce interface state and traps, a thin dielectric layer 121 of thermal silicon oxide SiO₂ can be formed (by thermal oxidation of the substrate 111). This dielectric layer 121 can be annealed to further reduce the density of embedded traps (e.g., at a temperature of 900°C and under nitrogen N₂).

We have presented the embodiment of FIG. 2, which corresponds to a particular arrangement of the reverse-doped pockets 114. We will now detail the manufacturing steps of the electrical device 100 according to another embodiment of the invention.

**FIGS. 3A-3C** illustrate steps of a method for manufacturing an electrical device according to embodiment of the invention.

The proposed method for manufacturing the electrical device 100 comprises (all or part of) the steps described hereinafter.

In FIG. 3A, a step is shown in which a mask M-A is formed on the substrate 111. This mask M-A comprises one or more openings in the peripheral region of the substrate 111 and covers the central portion of the substrate 111. The central region of the substrate 111 comprises the reliefs formed by the protruding walls 112, whereas the peripheral region of the substrate 111 does not comprises the reliefs formed by the protruding walls 112 and surrounds the central region of the substrate 111.

This figure also shows a step in which the reverse-doped pockets 114 are formed. Here, the reverse-doped pockets 114 are formed by doping the substrate 111 through the opening(s) in the mask M-A with a dopant of the second doping type (e.g., a n-type dopant). This can be performed using n-ion implantation for instance. Then, the mask M-A is removed.

In contrast to the embodiment of FIG.2, the embodiment of FIG. 3 defines an arrangement in which the reverse-doped pockets 114 extend only in the peripheral region of the substrate 111. This is advantageous in that it sufficiently increases the injection of minority carriers while having a negligible impact on the capacitance density of the capacitor. The surface area of the reverse-doped pockets 114 is small compared with the specific surface area of the capacitor. This results from the fact that the surface of the peripheral region of the substrate 111 is small compared with the top surface 111-TS of the substrate 111.

In FIG. 3B, a step is shown in which a mask M-B is formed on the substrate 111. This mask M-B comprises openings in the central region of the substrate 111 and covers the peripheral portion of the substrate 111. These openings define the reliefs to be formed by the protruding walls 112 (e.g., define the trench(es) to be formed in between the protruding walls 112).

This figure also shows a step in which the protruding walls 112 are formed. This can be performed by etching the substrate 111 through the openings in the mask M-B. Then, the mask M-B is removed.

In FIG. 3C, a step is shown in which the dielectric structure 120 is deposited conformally on the protruding walls 112 of the substrate 111.

This figure also shows a step in which the top electrode structure 130 is formed. The top electrode structure 110 is formed here by a conductive layer 131 (e.g., a layer of polysilicon) deposited on the dielectric structure 120.

As illustrated on this figure, the dielectric structure 120 comprises an opening onto the reverse-doped pockets 114. This opening is (partially or fully) filled with a conductive material 140 to form an electrical contact C3 with the reverse-doped pockets 114.

This electrical contact C3 to the reverse-doped pockets 114 can be used to connect the reverse-doped pockets 114 to other components and/or structures and define electrical circuits. For instance, the electrical contact C3 may be used to connect the reverse-doped pockets 114 to the substrate 111 via a metallic strap. It may also be used to connect the reverse-doped pockets 114 to a reverse bias source to increase carrier injection at the interface with the dielectric structure 120.

We now present examples of electrical circuits related to the proposed electrical device 100.

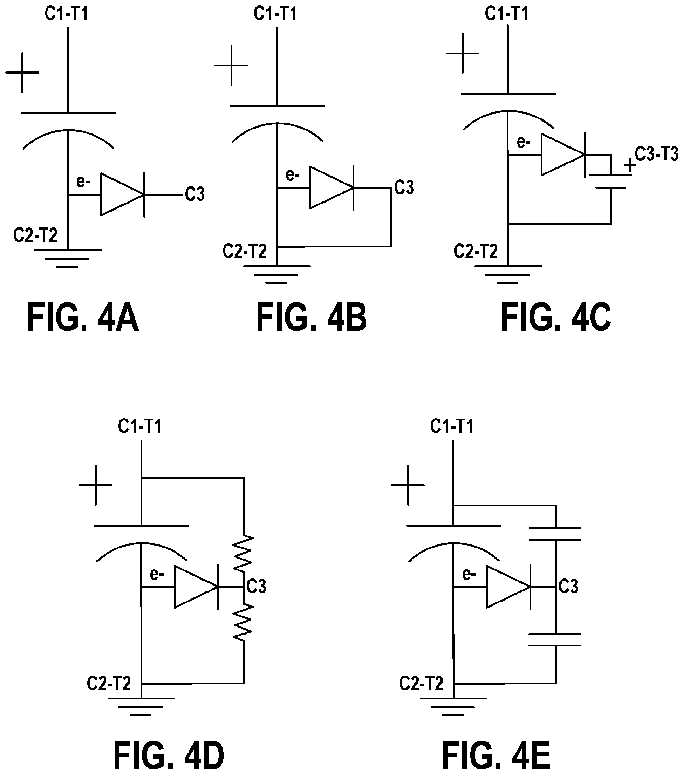

**FIGS. 4A-4E** illustrate electrical circuits related to different electrical devices according to embodiments of the present invention.

Before presenting various electrical circuits that can be implemented in relation to the proposed electrical device 100, we introduce some notations. We note here C1 the first electrical contact that is connected to the top electrode structure 130, C2 the second electrical contact that is connected to the bottom electrode structure 110, and C3 the third electrical contact that is connected to the reverse-doped pockets 114.

In addition, the electrical device 100 comprises a first external terminal T1 connected to first electrical contact C1 of the top electrode structure 110 and a second external terminal T2 connected to the second electrical contact C2 of the bottom electrode structure 130. In some embodiments, it may comprise a third external contact T3 connected to the third electrical contact C3 of the reverse-doped pockets 114. The external terminals T1 and T2 are to be connected to the terminals of a voltage supply, in particular a high-voltage supply (e.g., exceeding 900V, or in the range from 1200V to 2000V).

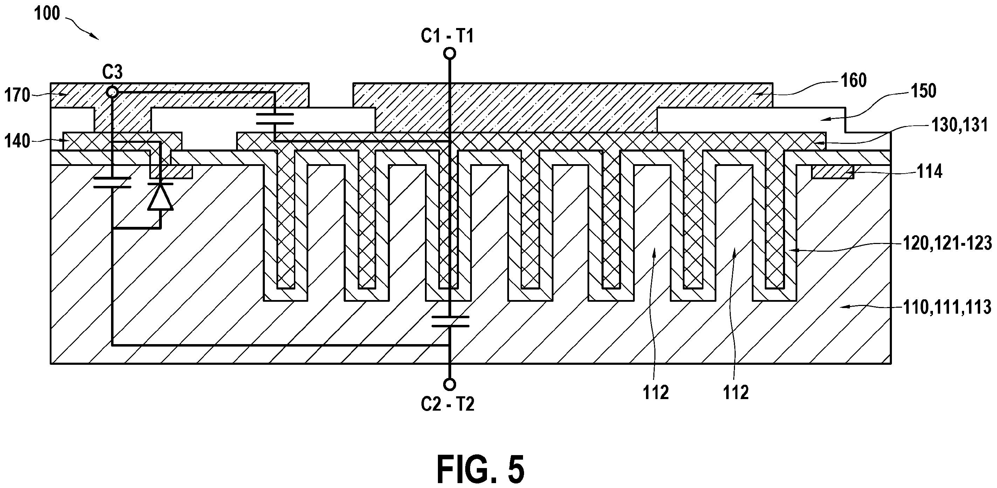

In the embodiments of FIGS. 4A-4E and 5, the substrate 110 has a first region 113 which is p-doped and second regions 114 which are n-doped. The positive potential is applied to terminal T1 (i.e., to the top electrode 130) and the ground is applied to terminal T2 (i.e., to the bottom electrode 110).

However, the present invention is not limited to these embodiments. It can be envisaged embodiments (not illustrated) wherein the substrate 111 has a first region 113 which is n-doped and second regions 114 which are p-doped, then the potentials applied to terminals T1 and T2 are reversed (i.e., the ground is applied to terminal T1 and the positive potential is applied to terminal T2) and the direction of the diode formed by the p-n junction is also reversed.

FIGS. 4A and 4B illustrate embodiments of the present invention in relation to thermionic diffusion.

As illustrated on these figures, the p-n junction formed at the interface between the first region of the first doping type 113 (e.g., p-doped) and the second regions of the second doping type 114 (e.g., n-doped) can be assimilated to a diode.

It is important to remember that the reverse-doped pockets 114 extend only partially over the top surface 111-TS of the substrate, so that the dielectric structure 120 extends over both the first region of the first doping type 113 and the second regions of the second doping type 114. This ensures that the diode formed by the p-n junction is in parallel with the capacitor (and not in series).

In the embodiment of FIG. 4A, the diode formed by the p-n junction is connected only at one of its ends to the bottom electrode structure 110 (i.e., C3 is either inexistent or left free). And, in the embodiment of FIG. 4B, the diode is electrically connected at both ends to the bottom electrode structure 110 (i.e., C3 is electrically connected to C2), for instance via a metallic strap.

In these embodiments, the reverse-doped pockets 114 are electrically insulated from other electrical components or structures. In particular, they are electrically insulated from the top electrode structure 130.

These embodiments propose using the thermionic diffusion of the reverse-doped pockets 114 to enhance minority carrier generation. That is, no reverse bias source is used. This is advantageous in that it offers a particularly low implementation complexity. This contributes to providing a capacitor capable of withstanding high voltages in both polarities, with a low implementation complexity.

FIG. 4C illustrates an embodiment of the present invention in relation to external injection.

In this embodiment, an external voltage supply is connected to external terminals T2 and T3. In other words, an external voltage supply is connected to the reverse-doped pockets 114 acting as a reverse bias source.

This allows increasing the minority carrier injection through the reverse-doped pockets 114. This embodiment provides a capacitor capable of withstanding high voltages in both polarities. The external voltage supply can also be used to dynamically control the source of the reversed bias.

FIGS. 4D-4E illustrate embodiments of the present invention in relation to self-injection.

In these embodiments, the voltage supply connected to the capacitor electrodes (i.e., connected to external terminals T1 and T2) is used as a reverse bias source. This increases the minority carrier injection through the reverse-doped pockets 114.

In these embodiments, the electrical device 100 comprises only two external terminals T1 and T2 respectively connected to the top and bottom electrode structures 110 and 130. The reverse-doped pockets 114 are internally connected with the top electrode structure 130 and the bottom electrode structure 110 (within the electrical device 100).

FIG. 4D illustrates an embodiment wherein a voltage dividing bridge is implemented. As illustrated, the reverse-doped pockets 114 are connected to the top electrode structure 130 through a resistive structure (i.e., C1 is connected to C3 via a resistor). And, the reverse-doped pockets 114 are connected to the bottom electrode structure 110 through another resistive structure (i.e., C3 is connected to C2 via a resistor).

FIG. 4E illustrates an embodiment wherein a capacitive dividing bridge is implemented. As illustrated, the reverse-doped pockets 114 are connected to the top electrode structure 130 through a capacitive structure (i.e., C1 is connected to C3 via a capacitor). And, the reverse-doped pockets 114 are connected to the bottom electrode structure 110 through another capacitive structure (i.e., C3 is connected to C2 via a capacitor). This allows filtering low-frequency signals (without using external capacitors), so that minority carrier injection is increased for high-frequency signals (e.g., transient pulses) when such injection is necessary.

To further illustrate the proposed solution, we present below an example implementation of the embodiment of FIG. 4E in relation to the following figure.

However, before presenting this example implementation, it should be noted that the various electrical circuits presented above can be combined. Within the scope of the present invention, embodiments could be envisaged wherein different reverse-doped pockets 114 are connected to different circuits.

For instance, some reverse-doped pockets 114 may be connected to the capacitor electrodes 110 and 130 (i.e., self-injection), while other reverse-doped pockets 114 may be insulated from the top electrode 130 (i.e., thermoionic diffusion). Also, the reverse-doped pockets 114 may be connected to the top electrode 110 via a resistor and a capacitor, and may be connected to the bottom electrode 130 via another resistor and another capacitor (i.e., self-injection).

**FIG. 5** illustrates a cross-section view of an electrical device according to an embodiment of the present invention.

This figure illustrates an embodiment wherein the voltage supply connected to the capacitor electrodes (i.e., connected to external terminals T1 and T2) is used as a reverse bias source.

In addition to the embodiment of FIG. 2, the electrical device 100 comprises here an insulating layer 150 (also referred to as the *"contact opening layer"*)*.* The insulating layer 150 comprises openings onto: i) the top electrode structure 130, and onto ii) the conductive layer 140 connected to the reverse-doped pockets 114. For instance, the insulating layer 150 is a layer of silicon oxide (SiO₂).

The electrical device 100 further comprises a conductive layer 160 in contact with the top electrode structure 130. It also comprises a conductive layer 170 in contact with the conductive layer 140 connected to the reverse-doped pockets 114.

More specifically, FIG. 5 illustrates an embodiment wherein a capacitive dividing bridge is implemented. The reverse-doped pockets 114 are connected to the top electrode structure 130 through a capacitive structure and are also connected to the bottom electrode structure 110 through another capacitive structure.

On the one hand, the capacitive structure connecting the reverse-doped pockets 114 to the top electrode structure 130 is formed by: i) the conductive layer 131 of the top electrode structure 130, and ii) the conductive layer 170 connected to the reverse-doped pockets 114, facing each other and separated by the insulating layer 150.

On the other hand, the capacitive structure connecting the reverse-doped pockets 114 to the bottom electrode structure 110 is formed by: i) the first region of the first doping type 113 of the substrate 111 and ii) the conductive layer 140 electrically connected to the reverse-doped pockets 114, facing each other and separated by the dielectric structure 120.

This embodiment allows using the voltage supply connected to the capacitor electrodes as a reverse bias source. The capacitive dividing bridge implemented in this embodiment allows filtering low-frequency signals, so that minority carrier injection is increased for high-frequency signals (i.e., when such injection is necessary). This embodiment thereby contributes to providing a capacitor capable of withstanding high voltages under both polarities and with a low implementation complexity.

**Additional Variants:** Although the present invention has been described above with reference to certain specific embodiments, it will be understood that the invention is not limited by the particularities of these specific embodiments. Numerous variations, modifications, and developments may be made in the above-described embodiments within the scope of the claims.

It is to be understood that references in this text to directions and locations, such as *"top"* and *"bottom", "highest"* and *"lowest"* merely refer to the directions that apply when architectures and components are oriented as illustrated in the accompanying drawings.

## Claims

1. An electrical device (100) including a capacitor comprising:
- a bottom electrode structure (110) comprising a semiconductor substrate (111), the substrate (111) having facing protruding walls (112) extending upwards,
- a dielectric structure (120) comprising one or more dielectric layers (121-123) and extending conformally on the protruding walls (112) of the substrate (111), and
- a top electrode structure (130) comprising at least one conductive layer (131) and extending conformally on the dielectric structure (120), the capacitor being formed by the bottom electrode structure (110) and the top electrode structure (130) facing each other and separated by the dielectric structure (120),
wherein:
- the substrate (111) comprises a first region of a first doping type (113) extending from a bottom surface (111-BS) of the substrate (111) up to a top surface (111-TS) of the substrate (111),
- the substrate (111) comprises one or more second regions of a second doping type (114), the first doping type and the second doping type having opposite charge carriers,
- said one or more second regions of the second doping type (114) extend from the top surface (111-TS) of the substrate (111) down to a given depth (111-D) of the substrate (111) and extend only partially over the top surface (111-TS) of the substrate (111), and
- the dielectric structure (120) extends on the first region of the first doping type (113) and on said one or more second regions of the second doping type (114).

2. The electrical device (100) according to claim 1, wherein said second regions of the second doping type (113) extend only in a peripheral region of the substrate (111).

3. The electrical device (100) according to claim 1, wherein said second regions of the second doping type (113) extend over substantially the entire of a highest surface (111-HS) of the substrate (111).

4. The electrical device (100) according to any of claims 1 to 3, wherein the given depth (111-D) of the substrate (111), to which said second regions of the second doping type (114) extend, is equal to or less than 30% of a thickness (111-T) of the substrate (111).

5. The electrical device (100) according to any of claims 1 to 4, wherein at least one of said second regions of the second doping type (114) is electrically connected only to the bottom electrode structure (110) and is electrically insulated from the top electrode structure (130).

6. The electrical device (100) according to any of claims 1 to 5, further comprising:
- a first external terminal (T1) electrically connected to the top electrode structure (130),
- a second external terminal (T2) electrically connected to the bottom electrode structure (110),
- a third external terminal (T3) electrically connected to at least one of said second regions of the second doping type (114).

7. The electrical device (100) according to any of claims 1 to 5, wherein the electrical device (100) comprises only two external terminals (T1, T2) respectively connected to the top and bottom electrode structures (130, 110), and at least one of said second regions of the second doping type (114) is internally connected with the top electrode structure (130) and/or the bottom electrode structure (110).

8. The electrical device (100) according to claim 7, wherein at least one of said second regions of the second doping type (114) is electrically connected to the top electrode structure (130) through a capacitive structure and is also electrically connected to the bottom electrode structure (110) through another capacitive structure.

9. The electrical device (100) according to claim 8, wherein:
- the capacitive structure connecting said second regions of the second doping type (114) to the top electrode structure (130) comprises:
∘ i) a conductive layer (131) of the top electrode structure (130) and ii) a conductive layer (170) electrically connected to said second regions of the second doping type (114), facing each other and separated by an insulating layer (150),
- the other capacitive structure connecting said second regions of the second doping type (114) to the bottom electrode structure (110) comprises:
∘ i) the first region of the first doping type (113) of the substrate (111) and ii) a conductive layer (140) electrically connected to said second regions of the second doping type (114), facing each other and separated by the dielectric structure (120).

10. The electrical device (100) according to any of claims 1 to 9, wherein the protruding walls (112) of the substrate (111) form one or more trenches.

11. The electrical device (100) according to any of claims 1 to 10, wherein the electrical device (100) is configured to be used with an operating voltage measured between the bottom electrode structure (110) and the top electrode structure (130) exceeding 900V, or 1200V.

12. A method for manufacturing an electrical device (100) including a capacitor, said method comprising:
- forming a bottom electrode structure (110) comprising a semiconductor substrate (111), the substrate (111) comprising:
∘ facing protruding walls (112) extending upwards,
∘ a first region of a first doping type (113) extending from a bottom surface (111-BS) of the substrate (111) up to a top surface (111-TS) of the substrate (111),
∘ one or more second regions of a second doping type (114), the first doping type and the second doping type having opposite charge carriers, said one or more second regions of a second doping type (114) extending from the top surface (111-TS) of the substrate (111) down to a given depth (111-D) of the substrate (111) and extending only partially over the top surface (111-TS) of the substrate (111),
wherein forming the bottom electrode structure (110) comprises:
∘ doping the substrate (111) with a dopant of the second doping type to form said one or more second regions of the second doping type (114),
- forming a dielectric structure (120) comprising one or more dielectric layers (121-123) extending conformally on the protruding walls (112) of the substrate (111), the dielectric structure (120) extending on the first region of the first doping type (113) and on said one or more second regions of the second doping type (114),
- forming a top electrode structure (130) comprising one or more conductive layers (131) and extending conformally on the dielectric structure (120).

13. The method according to claim 12, wherein forming the bottom electrode structure (110) comprises:
- forming a mask (M-A) on the substrate (111) comprising at least one opening in a peripheral region of the substrate (111), this mask (M-A) covering a central portion of the substrate (111),
- doping the substrate (111) through said at least one opening of the mask (M-A) with a dopant of the second doping type to form said second regions of the second doping type (114), and
- etching the substrate (111) in its central region to form the protruding walls (112).

14. The method according to claim 12, wherein forming the bottom electrode structure (110) comprises:
- etching the substrate (111) to form the protruding walls (112), and then
- full sheet doping the substrate (111) with a dopant of the second doping type using ion implementation to form said second regions of the second doping type (114),

15. The method according to claim 12, wherein forming the bottom electrode structure (110) comprises:
- forming a layer of the second doping type on the substrate (111) by using full-sheet epitaxy, and then
- etching the substrate (111) to form the protruding walls (112) and said second regions of the second doping type (114).
